# EUROPÄISCHE PATENTSCHRIFT

(11) **EP 1 864 561 B1**
(45) Veröffentlichungstag und Bekanntmachung des Hinweises auf die Patenterteilung: **08.05.2013**
(21) Anmeldenummer: 06722701.7
(22) Anmeldetag: 28.03.2006
(51) Int. Cl.: H05K 7/14, H05K 7/20

(54) **LEITERPLATTENANORDNUNG**
PRINTED CIRCUIT BOARD ASSEMBLY
ENSEMBLE CARTE DE CIRCUITS IMPRIMES

(30) Priorität: 31.03.2005 DE 102005014605
(43) Veröffentlichungstag der Anmeldung: 12.12.2007
(73) Patentinhaber: Conti Temic microelectronic GmbH, 90411 Nürnberg (DE)
(72) Erfinder: BINDER, Markus, 85092 Kösching (DE); SCHLENKER, Roberto, 85092 Kösching (DE); HOFFMANN, Richard, 85080 Gaimersheim (DE); DORFINGER, Georg, D-83278 Traunstein (DE)
(86) Internationale Anmeldenummer: PCT/DE2006/000549
(87) Internationale Veröffentlichungsnummer: WO 2006/102875

(56) Entgegenhaltungen:
- EP-A2- 0 991 308
- WO-A2-2004/034753
- DE-A1- 10 062 699

## Beschreibung

Die Erfindung betrifft eine Leiterplattenanordnung, welche eine Leiterplatte, ein Kühlblech sowie ein Kopplungselement umfasst, das zur thermischen Kopplung eines auf der Leiterplatte befindlichen Bauelementes mit dem Kühlblech vorgesehen und in einer Bohrung der Leiterplatte angeordnet ist. Eine derartige Leiterplattenanordnung ist beispielsweise aus der DE 196 01 649 A1 bekannt.

Bei der aus DE 196 01 649 A1 bekannten Leiterplattenanordnung kann das Kopplungselement in Form eines Noppen einteilig mit dem Kühlblech ausgebildet oder als separates Teil auf das Kühlblech aufgesetzt sein. In jedem Fall ist der Durchmesser des eine zylindrische Form aufweisenden Kopplungselementes geringer als der Durchmesser der Durchgangsbohrung in der Leiterplatte, in welcher sich das Kopplungselement befindet. Dies hat zur Folge, dass beim Heißverzinnen Lötzinn in den Spalt zwischen dem Kopplungselement und der Wandung der Durchgangsbohrung fließen kann. Der Vorgang des Auflötens des elektrischen oder elektronischen Bauelementes auf das Kopplungselement ist daher problematisch.

Eine weitere Leiterplattenanordnung mit einer so genannten Wärmesenke zur Kühlung eines Bauelementes ist beispielsweise aus der DE 42 20 966 C2 bekannt. Die Wärmesenke ist dabei durch einen Presssitz in einer Durchgangsöffnung der Leiterplatte fixiert. Von der Wärmesenke aus, welche die Grundform eines massiven Zylinders hat, kann Verlustwärme des Bauelementes in ein die Leiterplatte aufnehmendes Gehäuse abgeleitet werden. Eine mechanische Verbindung der Wärmesenke mit dem Gehäuse ist nicht vorgesehen.

Einfügen Eine nach weitere heiterplattenanordnung mit einer einstüchige Kühlvorshtung zur Montage ein einem Träger für euchtronische Bauelemente ist beispielsweise aus der DE 10062699A1 bekannt.

Der Erfindung liegt die Aufgabe zugrunde, eine Leiterplattenanordnung anzugeben, welche eine gute thermische Ankopplung eines elektrischen oder elektronischen Bauelementes an ein Kühlblech bei zugleich besonders rationeller Montagemöglichkeit gewährleistet.

Diese Aufgabe wird erfindungsgemäß gelöst durch eine Leiterplattenanordnung mit den Merkmalen des Anspruchs 1. Die Leiterplattenanordnung umfasst eine Leiterplatte, auf welcher ein Wärme abgebendes elektrisches oder elektronisches Bauelement anordenbar ist, ein mit der Leiterplatte verbundenes Kühlblech sowie ein Kopplungselement zur thermischen Kopplung des Bauelementes an das Kühlblech, wobei das Kopplungselement in einer Durchgangsbohrung der Leiterplatte angeordnet ist.

Erfindungsgemäß ist das Kopplungselement zur Herstellung einer mechanischen Verbindung zwischen der Leiterplatte und dem Kühlblech, insbesondere in der Art einer Nietverbindung, vorgesehen. Die Verbindung kann dabei kraft- und/oder formschlüssig oder stofflich sein. Von einer Nietverbindung wird in der Regel gesprochen, wenn zwei Bauteile, vermittelt durch ein drittes Bauteil, den Niet, formschlüssig und im Allgemeinen unlösbar verbunden sind. Im Folgenden wird der Begriff Nietverbindung in einem weiteren Sinne auch für mechanische Verbindungen verwendet, bei welchen der Niet die Bauteile, hier die Leiterplatte und das Kühlblech, lediglich kraftschlüssig verbindet und/oder einstückig mit einem der Bauteile ausgebildet ist. In jedem Fall erfüllt das Kopplungselement eine Doppelfunktion, nämlich zum einen die Funktion eines Wärme aus dem zu kühlenden Bauelement ableitenden Elementes und zum anderen die Funktion eines Niets, welcher das Kühlblech mit der Leiterplatte verbindet.

Der das Kopplungselement bildende Niet hat in unverformtem Zustand vorzugsweise einen Durchmesser, der den Durchmesser der Durchgangsbohrung in der Leiterplatte unterschreitet, so dass ein Spiel zwischen dem Niet und der Leiterplatte existiert. Insbesondere im Falle einer Mehrzahl an Nieten sowie korrespondierenden Durchgangsbohrungen in der Leiterplatte ist die Anordnung somit leicht montierbar und zugleich relativ unempfindlich gegenüber eventuellen geometrischen Toleranzen. Nach der Verformung des Niets, d.h. der Herstellung der mechanischen Verbindung zwischen dem Kühlblech und der Leiterplatte, füllt dagegen das Kopplungselement den Querschnitt der Durchgangsbohrung in der Leiterplatte vorzugsweise vollständig aus. Somit kann bei einem nachfolgenden Lötvorgang keine nennenswerte Menge an Lötzinn in die Durchgangsbohrung abfließen. Die Lötprozesse, mit welchen das elektrische oder elektronische Bauelement auf der Leiterplatte zu kontaktieren ist, sind somit gut beherrschbar. Soweit beim Löten eine geringe Menge an Lötzinn in die Durchgangsbohrung, in welcher sich der Niet befindet, fließt, trägt dies zusätzlich zur Stabilisierung der mechanischen Verbindung zwischen der Leiterplatte und dem Kühlblech bei.

Zur mechanischen Verbindung des Kühlblechs, welches in der Regel vollständig oder zumindest überwiegend an der Leiterplatte anliegt, mit dieser ist die Nietverbindung, welche durch das mindestens eine Kopplungselement gebildet ist, grundsätzlich ausreichend. Um sowohl die mechanische Verbindung als auch die thermische Ankopplung weiter zu verbessern, kann das Kühlblech zusätzlich mit der Leiterplatte verklebt sein, vorzugsweise unter Verwendung einer die Klebeverbindung herstellenden Folie. Die Klebung kann hierbei vollflächig oder nur in Teilbereichen des Kühlblechs sowie der Leiterplatte ausgebildet sein. Letztgenanntes gilt insbesondere in Fällen, in denen, wie unten stehend noch näher ausgeführt, das Kühlblech teilweise von der Leiterplatte absteht.

Der Wärmeausdehnungskoeffizient der Leiterplatte stimmt typischerweise nicht mit dem Wärmeausdehnungskoeffizienten des Kopplungselementes überein. Würde ein im wesentlichen zylindrisches, massives Kopplungselement die Durchgangsbohrung in der Leiterplatte vollständig oder nahezu vollständig ausfüllen, so könnte dies erhebliche thermisch bedingte mechanische Spannungen und daraus resultierende mechanische Beschädigungen bis hin zur Zerstörung der Leiterplatte zur Folge haben.

Um dieser Gefahr wirksam zu begegnen, weist das Kopplungselement vorzugsweise eine Wandstärke auf, die geringer als die Dicke der Leiterplatte ist. Die Wandstärke des Kopplungselementes ist hierbei nicht unbedingt einheitlich. Beispielsweise kann ein parallel zur Oberfläche der Leiterplatte angeordneter Bereich des Kopplungselementes eine Wandstärke aufweisen, die sich von der Wandstärke in Bereichen des Kopplungselementes unterscheidet, die normal zur Leiterplatte, d..h. in Axialrichtung der Durchgangsbohrung, angeordnet sind. Die Wandstärken beziehen sich stets auf das Kopplungselement in unverformtem Zustand. Durch die Verformung des Kopplungselementes in der Durchgangsbohrung kann sich die Wandstärke teilweise ändern. Dennoch verbleibt in der Durchgangsbohrung ein Hohlraum, welcher vorzugsweise ein größeres Volumen als der vom Material des Niets ausgefüllte Raum hat.

Die im Vergleich zur Leiterplatte relativ dünnwandige Ausbildung des Kopplungselementes hat in jedem Fall den Vorteil, dass eine zumindest geringfügige Nachgiebigkeit des Kopplungselementes erhalten bleibt, so dass thermisch induzierte mechanische Spannungen abgefangen werden. Zudem werden die bei der Herstellung der Nietverbindung auftretenden Kräfte relativ gering gehalten. Dies erleichtert es insbesondere, eine bereits teilbestückte Leiterplatte per Nietverbindung mit dem Kühlblech zu verbinden.

Nach einer ersten Ausführungsform ist das Kopplungselement einteilig mit dem Kühlblech ausgebildet. Das zur Herstellung der Nietverbindung vorgesehene Kopplungselement ist also aus dem Kühlblech heraus geformt. Diese Ausführungsform ist insbesondere vorteilhaft bei dünnwandigen Kühlblechen, deren Wandstärke geringer als die Wandstärke der Leiterplatte ist.

Nach einer alternativen Ausführungsform ist in das Kühlblech ein separater Niet als Kopplungselement eingesetzt. Diese Ausführungsform eignet sich insbesondere für dickwandige Kühlbleche, wobei die Wandstärke des Kühlblechs die Dicke der Leiterplatte übersteigen kann. Vorzugsweise sind der Niet und das Kühlblech aus verschiedenen Werkstoffen gefertigt, die auf die jeweiligen Anforderungen an die Verformbarkeit und Wärmeleitfähigkeit abgestimmt sind.

Insbesondere in Ausführungsformen mit im Vergleich zur Leiterplatte dickwandigem Kühlblech kann das Kühlblech auf einfache Weise zusätzliche Funktionen übernehmen. So kann das Kühlblech auf der dem Bauelement abgewandten Seite der Leiterplatte eine Tasche zur Aufnahme eines weiteren Bauelementes, mit dem die Leiterplatte bestückt ist, bilden. Das Kühlblech ist somit auch für zweiseitig bestückte Leiterplatten verwendbar. Des Weiteren hat diese Ausführungsform den Vorteil, dass die durch das Kühlblech geformte Tasche zur Aufnahme eines Bauelementes zugleich eine Abschirmung gegenüber elektromagnetischer Strahlung bildet. Die Abschirmfunktion kann sich hierbei auf die vom Bauelement emittierte Strahlung und/oder auf einstrahlende elektromagnetische Wellen beziehen.

Zusätzlich oder alternativ kann ein Teil des Kühlblechs auch als Abstandshalter ausgeführt sein, welcher vorzugsweise einen Fuß hat, der von der Leiterplatte parallel beabstandet ist. Über diesen Fuß ist Verlustwärme eines oder mehrerer Bauelemente beispielsweise in ein Gehäuse abführbar, dessen Wandung, auf welcher der Fuß des Abstandshalters befestigt ist, parallel zur Leiterplatte angeordnet ist. Die Halterung der Leiterplatte mit definiertem Abstand zur Gehäusewandung hat zudem den Vorteil einer guten Belüftbarkeit der bevorzugt beidseitig bestückten Leiterplatte.

Der Vorteil der Erfindung liegt insbesondere darin, dass ein thermisches Ankopplungselement zwischen einem Bauelement auf einer Leiterplatte und einem Kühlblech auf der dem Bauelement abgewandten Seite der Leiterplatte gleichzeitig eine Nietverbindung bildet, welche eine Durchgangsbohrung in der Leiterplatte zumindest weitgehend abdichtet. Damit ist die Leiterplattenanordnung mit besonders geringem Montage- und Prüfaufwand herstellbar.

Nachfolgend werden mehrere Ausführungsbeispiele anhand einer Zeichnung näher erläutert. Hierin zeigen in teilweise schematisierter Darstellung:
- Fig. 1: eine Leiterplattenanordnung mit Kühlblech,
- Fig. 2: eine Vorrichtung zur Herstellung einer Nietverbindung in der Leiterplattenanordnung nach Fig. 1,
- Fig. 3a, 3b, 3c: verschiedene Möglichkeiten der Herstellung einer Nietverbindung in einer Leiterplattenanordnung nach Fig. 1,
- Fig. 4: ein zweites Ausführungsbeispiel einer Leiterplattenanordnung mit Kühlblech,
- Fig. 5: ein drittes Ausführungsbeispiel einer Leiterplattenanordnung mit Kühlblech,
- Fig. 6: eine Vorrichtung zur Herstellung einer Nietverbindung in der Leiterplattenanordnung nach Fig. 5, und
- Fig. 7a, 7b, 7c, 7d: verschiedene Schritte der Herstellung einer Nietverbindung in einer Leiterplattenanordnung nach Fig. 5.

Einander entsprechende oder gleich wirkende Teile sind in allen Figuren mit denselben Bezugszeichen versehen.

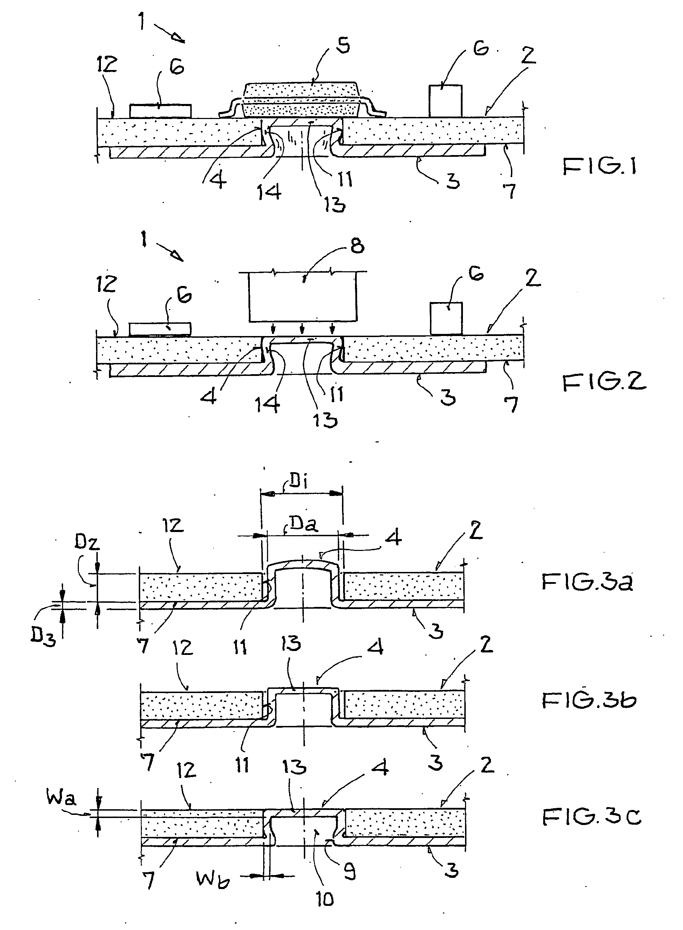

Die Fig. 1 zeigt in vereinfachtem Querschnitt ein erstes Ausführungsbeispiel einer Leiterplattenanordnung 1, welche eine Leiterplatte 2, ein an dieser anliegendes Kühlblech 3 sowie ein Kopplungselement 4 umfasst, das zur thermischen Ankopplung eines elektrischen oder elektronischen Bauelementes 5, insbesondere eines Leistungsbauteils, an das Kühlblech 3 vorgesehen ist. Weitere Bauelemente auf der Leiterplatte 2, welche eine relativ geringe Verlustleistung haben, sind mit dem Bezugszeichen 6 gekennzeichnet. Das Kühlblech 3 liegt an der den Bauelementen 5,6 abgewandten Unterseite 7 der Leiterplatte 2 an und ist mittels einer nicht sichtbaren Prepreg-Folie mit der Leiterplatte 2 verklebt. Durch die großflächige Verbindung des Kühlblechs 3 mit der Leiterplatte 2 kann auch deren Wärmekapazität zur Aufnahme von Verlustleistung des Bauelementes 5 und zur Wärmeweiterleitung genutzt werden.

Den überwiegenden Beitrag zur Leitung von Wärme vom Bauelement 5 an das Kühlblech 3 leistet das Kopplungselement 4, welches eine Nietverbindung zwischen dem Kühlblech 3 und der Leiterplatte 2 bildet. Im Ausführungsbeispiel nach Fig. 1 ist das auch als Niet bezeichnete Kopplungselement 4 einteilig mit dem Kühlblech 3 ausgebildet und beispielsweise aus Kupfer gefertigt.

Die Verformung des Niets 4 bei der Herstellung der Leiterplattenanordnung 1 verdeutlicht Fig. 2. Ein Pressstempel 8 verformt das Kopplungselement 4, welches in Fig. 2 bereits in verformtem Zustand dargestellt ist, derart, dass der entstandene Niet 4 den Querschnitt der mit dem Bezugszeichen 11 gekennzeichneten Durchgangsbohrung der Leiterplatte 2 vollständig ausfüllt und zugleich eine praktisch plane Fläche auf der Oberseite 12 der Leiterplatte 2 bildet.

Die durch das Kopplungselement 4 hergestellte Nietverbindung einerseits sowie die Verklebung durch die zwischen dem Kühlblech 3 und der Leiterplatte 2 angeordnete Laminierschicht (Prepreg-Folie) andererseits ergänzen sich sowohl hinsichtlich der wärmeleitenden als auch der mechanischen Funktion. Wie in Fig. 2 dargestellt, kann die Verformung des Kopplungselementes 4 bei teilbestückter Leiterplatte 2 erfolgen. Lediglich das Bauelement 5 ist nach der Verformung des Kopplungselementes 4 auf dieses aufzulöten. Da das Kopplungselement 4 die Durchgangsbohrung 11 praktisch vollständig ausfüllt, kann kein Lötzinn in die Durchgangsbohrung 11 fließen.

Die Fig. 3a bis 3c verdeutlichen den Vorgang der Vorformung des Kopplungselementes 4, wobei in den Fig. 3a und 3b zwei unterschiedliche mögliche Formen des unverformten Kopplungselementes 4 dargestellt sind. Die Fig. 3c zeigt das mit Hilfe des Pressstempels 8 fertig verformte Kopplungselement 4, wie auch in den Fig. 1 und 2 dargestellt, wobei die Ausgangsform des Kopplungselementes 4 der Variante nach Fig. 3a oder der Variante nach Fig. 3b entsprechen kann. Wie aus den Fig. 3a und 3b hervorgeht, ist der ursprüngliche Durchmesser Dₐ des Kopplungselementes 4 deutlich geringer als der Innendurchmesser Dᵢ der Durchgangsbohrung 11. Das Kopplungselement 4 kann somit sehr leicht in die Durchgangsbohrung 11 der Leiterplatte 2 eingesteckt werden. Dies gilt auch, falls die Lage des Kopplungselementes 4 und/oder der Durchgangsbohrung 11 mit geometrischen Toleranzen behaftet ist, auch in Fällen, in denen das Kühlblech 3 mehrere Kopplungselemente 4 aufweist.

Wie aus den Fig. 3a und 3b weiter hervorgeht, ragt das Kopplungselement 4 deutlich über die Durchgangsbohrung 11 hinaus. Die Dicke der Leiterplatte 2 ist mit D₂, die Wandstärke des Kühlblechs 3 mit D₃ bezeichnet. Das Kopplungselement 4, wie in den Fig. 3a und 3b dargestellt, ist durch Verformung aus dem Blech des Kühlblechs 3 geformt, so dass Wandstärken Wₐ,W_{b} des Kopplungselementes 4 etwas geringer als die Wandstärke D₃ des Kühlblechs 3 sind. In allen Bereichen ist die Wandstärke D₃,Wₐ,W_{b} des Kühlblechs 3 einschließlich Kopplungselement 4 wesentlich geringer als die Dicke D₂ der Leiterplatte 2. Die Wandstärke Wₐ,W_{b} des Kopplungselementes 4, welche sich durch den Verpressvorgang teilweise erhöhen kann, beträgt weniger als die Hälfte, insbesondere weniger als ein Viertel, der Dicke D₂ der Leiterplatte 2. Dadurch ist ein Verpressvorgang mit geringen Kräften möglich. Durch die zumindest nahezu vollständig plane Ausbildung der Oberfläche des Kopplungselementes 4 auf der Oberseite 12 der Leiterplatte 2 nach dem Verpressvorgang ist zugleich eine gute thermische Ankopplung des Bauelementes 5 an das Kühlblech 3 gegeben. Hierbei liegt ein bündig mit der Oberseite 12 der Leiterplatte 2 angeordnetes, kreisscheibenförmiges Kontaktstück 13 des Kopplungselementes 4 am Bauelement 5 an, während eine Wandung 14 des Kopplungselementes 4 an der Wandung der Durchgangsbohrung 11 anliegt und dabei eine kraftschlüssige Verbindung zwischen der Leiterplatte 2 und dem Kühlblech 3 bildet.

Im Ausführungsbeipiel nach Fig. 1 ist die Durchgangsbohrung 11 der Leiterplatte 2 ebenso wie die Wandung 14 des Kopplungselementes 4 exakt zylindrisch. Die durch das Kopplungselement 4 hergestellte Verbindung zwischen der Leiterplatte 2 und dem Kühlblech 3 ist in diesem Fall kraftschlüssig, nicht jedoch formschlüssig. In Abwandlung der dargestellten Ausführungsform kann die Durchgangsbohrung 11 beispielsweise leicht konisch, mit zur Oberseite 12 hin zunehmendem Durchmesser, gestaltet sein, so dass die durch des Kopplungselement 4 hergestellte Verbindung zusätzlich formschlüssig ist. In jedem Fall füllt das Material des Kopplunselementes 4 die Durchgangsbohrung 11 nicht vollständig aus. Vielmehr füllen das parallel zur Leiterplatte 2 angeordnete Kontaktstück 13, die Wandung 14, sowie eine am Übergang zwischen Wandung 14 und Kühlblech 3 gebildete Wulst 9 das Volumen der Durchgangsbohrung 11 zu weniger als die Hälfte auf, so dass in der Durchgangsbohrung 11 ein Hohlraum 10 verbleibt.

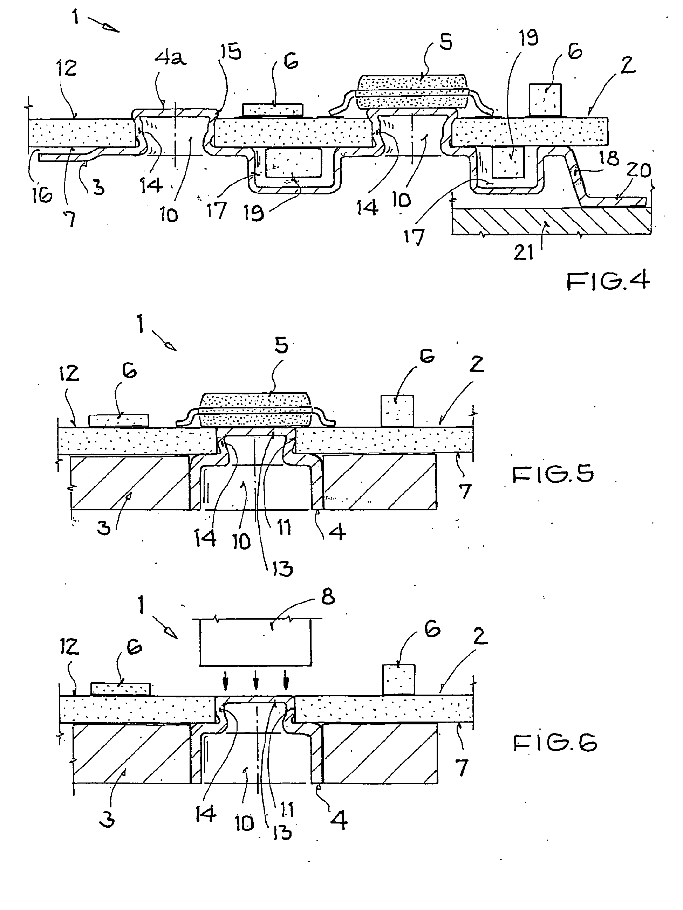

Die Fig. 4 zeigt ein Ausführungsbeispiel einer Leiterplattenanordnung 1, welches im Vergleich zu dem vorstehend beschriebenen Ausführungsbeispiel mehrere zusätzliche Merkmale aufweist. Ein in Fig. 4 links angeordnetes Kopplungselement 4a stellt zwischen der Leiterplatte 2 und dem Kühlblech 3 nicht nur eine kraftschlüssige sondern auch eine formschlüssige Verbindung her. Das Kopplungselement 4 überragt dabei die Leiterplatte 2 auf deren Oberseite 12 derart, dass im verformten Zustand des Kopplungselements 4 eine Wulst 15 ausgebildet ist, die radial über den Rand der Durchgangsbohrung 11 hinausragt..In nicht dargestellter Weise kann auch das Kopplungselement 4a, wie das in Fig. 4 rechts von diesem angeordnete Kopplungselement 4, ein elektrisches oder elektronisches Bauelement 5 tragen.

Im Unterschied zum Ausführungsbeispiel nach Fig. 1 ist im Ausführungsbeispiel nach Fig. 4 das Kühlblech 3 nicht mit der Leiterplatte 2 verklebt. Ein Spalt 16 zwischen der Leiterplatte 2 und dem Kühlblech 3 ist übertrieben groß dargestellt. Abweichend von der im Wesentlichen ebenen Form des Kühlblechs 3 auf der Unterseite 7 der Leiterplatte 2 sind in Fig. 4 zwei so genannte Taschen 17 sowie ein Abstandshalter 18 sichtbar. Die Taschen 17 decken jeweils ein Bauelement 19 ab und dienen damit als Abschirmung für diese Bauelemente 19. In nicht dargestellter Weise können sich innerhalb einer Tasche 17 auch mehrere Bauelemente 19 befinden. Ein Teil des Abstandshalters 18 ist als Fuß 20 ausgebildet, der parallel zur Leiterplatte 2 angeordnet ist und an einer Gehäusewandung 21 anliegt. Durch das flächige Anliegen des Fußes 19 an der Gehäusewandung 21 ist ein guter Wärmeabfluss an ein nicht weiter dargestelltes Gehäuse, in welchem sich die Leiterplattenanordnung 1 befindet, gegeben.

Die Fig. 5 und 6 zeigen ein weiteres Ausführungsbeispiel einer Leiterplattenanordnung 1, wobei in diesem Fall das Kühlblech 3 im Vergleich zur Leiterplatte 2 besonders dick ist. Die Wandstärke D₃ des Kühlblechs ist deutlich größer als die Dicke D₂ der Leiterplatte 2. In diesem Fall ist das Kopplungselement 4 kein Teil des Kühlbleches 3, sondern als separater Niet 4 in das Kühlblech 3 eingesetzt. Die Relationen zwischen der Wandstärke Wₐ,W_{b} des Kopplungselementes 4 und der Dicke D₂ der Leiterplatte 2 entsprechen etwa den im Ausführungsbeispiel nach Fig. 1 gegebenen Relationen. Somit ist das Kopplungselement 4 der Leiterplattenanordnung 1 nach Fig. 5 und 6 mit im Vergleich zu Kräften, die zur Verformung des Kühlblechs 3 notwendig wären, relativ geringen Kräften verformbar.

Das dickwandige Kühlblech 3 nach Fig. 5 und 6 ist aus Aluminium oder einem sonstigen Leichtmetallwerkstoff gefertigt, während der Niet 4 aus Kupfer hergestellt ist und besonders gute Verformungseigenschaften aufweist. Die Verformung des Nietes 4 beim Zusammenbau der Leiterplattenanordnung 1 geschieht, wie in Fig. 6 angedeutet, mittels eines Pressstempels 8 ähnlich wie im Ausführungsbeispiel nach Fig. 2. Entsprechend diesem Ausführungsbeispiel ist auch bei der Leiterplattenanordnung 1 nach den Fig. 5 und 6 das Kühlblech 3 mittels einer Prepreg-Folie mit der Leiterplatte 2 stofflich verbunden. Die durch das Kopplungselement 4 gegebene mechanische Verbindung zwischen dem Kühlblech 3 und der Leiterplatte 2 braucht daher nur einen Teil der Haltekräfte zwischen den genannten Teilen 2,3 aufzubringen. Die im Vergleich zum Kühlblech 3 sehr dünnwandige Gestaltung des Nietes 4 hat nicht nur montagetechnische Vorteile, sondern darüber hinaus insbesondere den Vorteil, dass Kräfte, die aufgrund unterschiedlicher Temperaturbeanspruchungen, insbesondere durch die Wärmeentwicklung des Bauelementes 5, entstehen, nicht zu unzulässigen Belastungen der Leiterplatte 2 oder anderer Teile der Leiterplattenanordnung 1 führen.

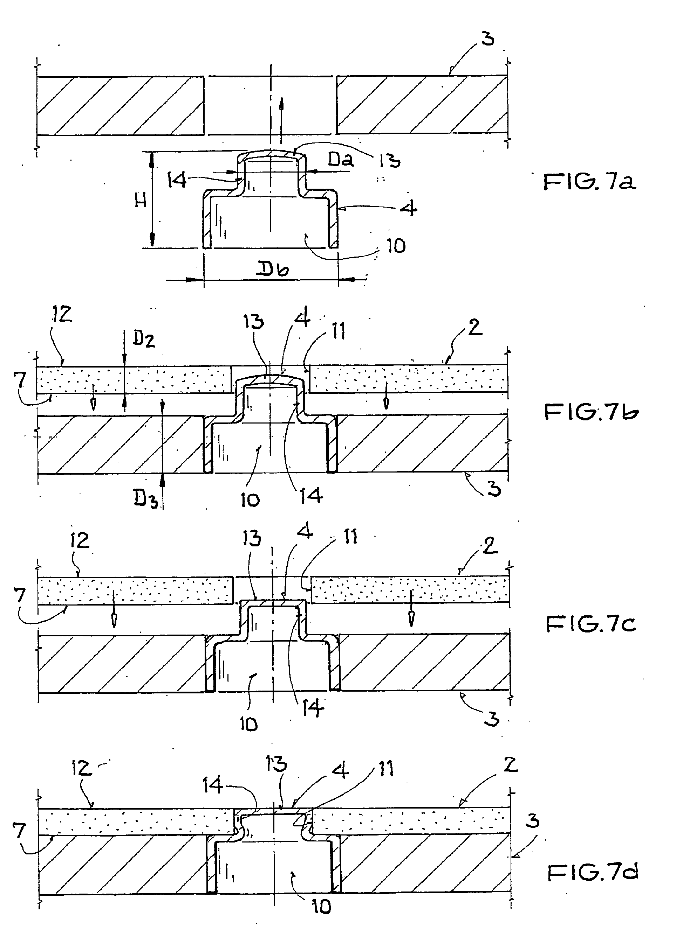

Die Verbindung des Kühlblechs 3 mit der Leiterplatte 2 mittels des Kopplungselementes 4 bei der Leiterplattenanordnung 1 nach den Fig. 5 und 6 ist in den Fig. 7a bis 7d weiter veranschaulicht. Zunächst wird das vorgefertigte Kopplungselement 4, auch als Kühlniet oder Blecheinzug bezeichnet, in die Durchgangsbohrung 11 der Leiterplatte 2 eingesetzt. Das Kopplungselement 4 hat die Grundform zweier koaxial aufeinandergesetzter Zylinder mit den Durchmessern Dₐ und D_{b}. Die Gesamthöhe H des Kopplungselementes 4 ist etwas größer als die Summe aus der Wandstärke D₃ des Kühlblechs 3 und der Dicke D₂ der Leiterplatte 2. Das kreisscheibenförmige, zum Auflöten des Bauelementes 5 vorgesehene Kontaktstück 13 des Kopplungselementes 4 kann, wie in den Fig. 7a und 7b erkennbar, leicht nach außen, d.h. zur Oberseite 12 hin, gewölbt, oder, entsprechend dem Ausführungsbeispiel nach Fig. 7c, eben sein.

Vor der Verbindung des Kühlblechs 3 mit der Leiterplatte 2 wird das mindestens eine Kopplungselement 4 in das Kühlblech 3 eingesetzt, wie in Fig.. 7b und 7c dargestellt. Anschließend wird die Leiterplatte 2 unter Druck mit dem Kühlblech 3 verklebt, d.h. laminiert. In einem letzten Verarbeitungsschritt wird das Kopplungselement 4 verformt, so dass sich die in Fig. 7d dargestellte Verbindung ergibt. Während dieses Verformvorgangs oder in einem vorherigen Verarbeitungsschritt wird mittels eines geeigneten, nicht dargestellten Werkzeuges das Kopplungselement derart verformt, dass dieses sowohl mit der Leiterplatte 2 als auch mit dem Kühlblech 3 zumindest kraftschlüssig verbunden ist. Das Kopplungselement 4 hat auch im verpressten Zustand, wie in Fig. 7d dargestellt, die Grundform eines gestuften Zylinders, wobei im Vergleich zur ursprünglichen Form des Kopplungselementes 4 der größere Durchmesser D_{b} im Bereich des Kühlblechs 3 im Wesentlichen unverändert ist, während der Durchmesser Dₐ im Bereich der Leiterplatte 2 auf den Durchmesser Dᵢ der Durchgangsbohrung 11 aufgeweitet ist. Auf diese Weise ist die Durchgangsbohrung 11 gegenüber auf der Oberseite 12 der Leiterplatte 2 befindlichem Lötmaterial zumindest nahezu vollständig abgedichtet.

### Bezugszeichenliste

| | |
|---|---|
| 1 | Leiterplattenanordnung |
| 2 | Leiterplatte |
| 3 | Kühlblech |
| 4, 4a | Kopplungselement |
| 5 | Bauelement |
| 6 | Bauelement |
| 7 | Unterseite |
| 8 | Pressstempel |
| 9 | Wulst |
| 10 | Hohlraum |
| 11 | Durchgangsbohrung |
| 12 | Oberseite |
| 13 | Kontaktstück |
| 14 | Wandung |
| 15 | Wulst |
| 16 | Spalt |
| 17 | Tasche |
| 18 | Abstandshalter |
| 19 | Bauelement |
| 20 | Fuß |
| 21 | Gehäusewandung |
| | |
| Dₐ, D_{b} | Durchmesser des Kopplungselementes |
| Dᵢ | Innendurchmesser der Durchgangsbohrung |
| D₂ | Dicke der Leiterplatte |
| D₃ | Dicke des Kühlblechs |
| H | Gesamthöhe des Kopplungselementes |
| Wₐ,W_{b} | Wandstärke des Kopplungselementes |

## Patentansprüche

1. Leiterplattenanordnung, umfassend eine Leiterplatte (2) zum Tragen eines elektrischen oder elektronischen Bauelementes (5,6), ein zur Ableitung von Wärme aus dem Bauelement (5,6) vorgesehenes, mit der Leiterplatte (2) verbundenes Kühlblech (3), sowie ein zur thermischen Kopplung des Bauelementes (5,6) an das Kühlblech (3) vorgesehenes, in einer Durchgangsbohrung (11) der Leiterplatte (2) angeordnetes Kopplungselement (4), wobei die Leiterplatte (2) mit dem Kühlblech (3) mittels des Kopplungselementes (4) mechanisch verbunden ist und durch das Kopplungselement (4) eine die Leiterplatte (2) mit dem Kühlblech (3) verbindende Nietverbindung gebildet ist,
**dadurch gekennzeichnet, dass**
in das Kühlblech (3) ein separater Niet (4) als Kopplungselement (4) eingesetzt ist.

2. Leiterplattenanordnung nach Anspruch 1,
**dadurch gekennzeichnet, dass**
der Niet (4) den Querschnitt der Durchgangsbohrung (11) vollständig ausfüllt.

3. Leiterplattenanordnung nach Anspruch 1 oder 2,
**dadurch gekennzeichnet, dass**
das Kühlblech (3) mit der Leiterplatte (2) verklebt ist.

4. Leiterplattenanordnung nach einem der Ansprüche 1 bis 3,
**dadurch gekennzeichnet, dass**
eine Wandstärke (Wₐ,W_{b}) des Nietes (4) geringer als die Dicke (D₂) der Leiterplatte (2) ist.

5. Leiterplattenanordnung nach Anspruch 1,
**dadurch gekennzeichnet, dass**
der Niet (4) und das Kühlblech (3) aus verschiedenen Werkstoffen gefertigt sind.

6. Leiterplattenanordnung nach einem der Ansprüche 1 bis 5,
**dadurch gekennzeichnet, dass**
die Dicke (D₃) des Kühlblechs die Dicke (D₂) der Leiterplatte (3) übersteigt.

7. Leiterplattenanordnung nach einem der Ansprüche 1 bis 6,
**dadurch gekennzeichnet, dass**
das Kühlblech (3) auf der dem Bauelement (5) abgewandten Seite der Leiterplatte (2) eine Tasche (16) zur Aufnahme eines weiteren Bauelementes (19), mit welchem die Leiterplatte (2) bestückt ist, bildet.

8. Leiterplattenanordnung nach einem der Ansprüche 1 bis 7,
**dadurch gekennzeichnet, dass**
das Kühlblech (3) einen von der Leiterplatte (2) beabstandeten Abstandshalter (17) bildet.

## Claims

1. A printed circuit board arrangement comprising a printed circuit board (2) for supporting an electric or electronic component (5, 6), a cooling plate (3) provided for removing heat from the component (5, 6) and connected to the printed circuit board (2) as well as a coupling element (4) provided for thermally coupling the component (5, 6) to the cooling plate (3) and arranged in a thru-bore (11) of the printed circuit board (2), wherein the printed circuit board (2) is mechanically connected to the cooling plate (3) by means of the coupling element (4) and a riveted joint connecting the printed circuit board (2) to the cooling plate (3) is formed by the coupling element (4),
**characterized in that**
a separate rivet (4) constituting the coupling element (4) is inserted in the cooling plate (3).

2. The printed circuit board arrangement according to claim 1,
**characterized in that**
the rivet (4) completely takes up the cross-section of the thru-bore (11).

3. The printed circuit board arrangement according to claim 1 or 2,
**characterized in that**
the cooling plate (3) and the printed circuit board (2) are conglutinated.

4. The printed circuit board arrangement according to any one of claims 1 to 3,
**characterized in that**
a wall thickness (Wₐ, W_{b}) of the rivet (4) is smaller than the thickness (D₂) of the printed circuit board (2).

5. The printed circuit board arrangement according to claim 1,
**characterized in that**
the rivet (4) and the cooling plate (3) are made of different materials.

6. The printed circuit board arrangement according to any one of claims 1 to 5,
**characterized in that**
the thickness (D₃) of the cooling plate exceeds the thickness (D₂) of the printed circuit board (3).

7. The printed circuit board arrangement according to any one of claims 1 to 6,
**characterized in that**
the cooling plate (3) forms, on that side of the printed circuit board (2) which faces away from the component (5), a pocket (16) for accommodating a further component (19) assembled to the printed circuit board (2).

8. The printed circuit board arrangement according to any one of claims 1 to 7,
**characterized in that**
the cooling plate (3) forms a spacer (17) spaced apart from the printed circuit board (2).

## Revendications

1. Dispositif de carte de circuit imprimé, comprenant une carte de circuit imprimé (2) destinée à porter un composant (5, 6) électrique ou électronique, une tôle de refroidissement (3) prévue pour la dérivation de la chaleur provenant du composant (5, 6) et raccordée à la carte de circuit imprimé (2), ainsi qu'un élément de couplage (4) prévu pour le couplage thermique du composant (5, 6) à la tôle de refroidissement (3) et disposé dans un alésage de traversée (11) de la carte de circuit imprimé (2), la carte de circuit imprimé (2) étant raccordée mécaniquement à la tôle de refroidissement (3) au moyen de l'élément de couplage (4), et un raccordement rivé étant formé à travers l'élément de couplage (4) et raccordant la carte de circuit imprimé (2) à la tôle de refroidissement (3),
**caractérisé en ce**
**qu'**un rivet séparé (4) est introduit dans la tôle de refroidissement (3) en tant qu'élément de couplage (4).

2. Dispositif de carte de circuit imprimé selon la revendication 1,
**caractérisé en ce que**
le rivet (4) remplit complètement la section transversale de l'alésage de traversée (11).

3. Dispositif de carte de circuit imprimé selon la revendication 1 ou 2,
**caractérisé en ce que**
la tôle de refroidissement (3) est collée à la carte de circuit imprimé (2).

4. Dispositif de carte de circuit imprimé selon une des revendications 1 à 3,
**caractérisé en ce**
**qu'**une épaisseur de paroi (Wₐ, W_{b}) du rivet (4) est plus petite que l'épaisseur (D₂) de la carte de circuit imprimé (2).

5. Dispositif de carte de circuit imprimé selon la revendication 1,
**caractérisé en ce que**
le rivet (4) et la tôle de refroidissement (3) sont réalisés en matériaux différents.

6. Dispositif de carte de circuit imprimé selon une des revendications 1 à 5,
**caractérisé en ce que**
l'épaisseur (D₃) de la tôle de refroidissement est plus importante que l'épaisseur (D₂) de la carte de circuit imprimé (3).

7. Dispositif de carte de circuit imprimé selon une des revendications 1 à 6,
**caractérisé en ce que**
la tôle de refroidissement (3) forme, sur le côté de la carte de circuit imprimé (2) qui est éloigné du composant (5), une poche (16) destinée à recevoir un autre composant (19) dont est équipée la carte de circuit imprimé (2).

8. Dispositif de carte de circuit imprimé selon une des revendications 1 à 7,
**caractérisé en ce que**
la tôle de refroidissement (3) forme un élément d'espacement (17) distant de la carte de circuit imprimé (2).
